# EUROPEAN PATENT APPLICATION

(11) **EP 4 243 058 A1**
(43) Date of publication of application: **13.09.2023**
(21) Application number: 22160553.8
(22) Date of filing: 07.03.2022
(51) Int. Cl.: H01L 21/60, H05K 1/18, H01L 23/31, H01L 23/495

(54) **A SEMICONDUCTOR PACKAGE AND A SEMICONDUCTOR DEVICE MODULE COMPRISING THE SAME**

(71) Applicant: Infineon Technologies Austria AG, 9500 Villach (AT)
(72) Inventor: FUERGUT, Edward, 86453 Dasing (DE); FAELSCHLE, Annette, 82008 Unterhaching (DE); NIKITIN, Ivan, 93057 Regensburg (DE); SCHMOELZER, Bernd, 9545 Radenthein (AT); SCHOLZ, Wolfgang, 82140 Olching (DE)
(74) Representative: Lambsdorff & Lange Patentanwälte Partnerschaft mbB

(57) **Abstract**

A semiconductor package (10; 20; 30) comprises a die carrier (11) comprising a first main face and a second main face opposite to the first main face, a semiconductor die (12) disposed on the die carrier (11), the semiconductor die (12) comprising a first pad and a second pad, a first electrical connector (14) disposed on the first pad, an encapsulant (15; 25; 35) at least partially covering the semiconductor die (13), the die carrier (11), and the first electrical connector (14); and an insulation layer (16; 26; 35A) disposed on the second main face of the die carrier (11).

## Description

### TECHNICAL FIELD

The present disclosure is related to a semiconductor package and a semiconductor device module comprising the same.

### BACKGROUND

Over the last couple of years a lot of activities have been carried out concerning the embedding of passive components and active semiconductor dies into PCB or package carrier systems. Some low voltage use cases have found their way into production as embedding provides additional value compared to module or discrete packaging solutions, such as compactness (power density), short lead lengths leading to remarkably low parasitic inductances, good thermal management and significantly improved power cycling capability. These benefits are also seen to be attractive for power applications with high voltages up to 1200 V and specially for fast switching applications > 20 kHz. Nevertheless, some existing blocking points, when looking at how chip embedding is done today, have to be solved first as in the future peak voltages of 1700V, 2000V or even higher are under consideration.

The current chip embedding process does not fulfil high voltage application requirements. The breakdown voltage, ion impurity level (sodium, chlorine, etc.) and the overall reliability of current PCB materials that are used for chip embedding are not suitable for 650 V (or even below) devices. Another problem is the missing pre-test capability in the current chip embedding process. Only a finished product can be tested for insulation properties and not a semiconductor package which is to be inserted into a printed circuit board.

For these and other reasons there is a need for the present disclosure.

### SUMMARY

A first aspect of the present disclosure is related to a semiconductor package comprising a die carrier comprising a first main face and a second main face opposite to the first main face, a semiconductor die disposed on the die carrier, the semiconductor die comprising a first pad and a second pad, a first electrical connector disposed on the first pad, an encapsulant at least partially covering the semiconductor die, the die carrier, and the first electrical connector, and an insulation layer disposed on the second main face of the die carrier.

A second aspect of the present disclosure is related to a semiconductor device module comprising a package carrier comprising an opening, wherein a semiconductor package according to the first aspect is disposed in the opening.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows a schematic cross-sectional side view representation of an example of a semiconductor package in which the insulation layer is applied to rear surfaces of the die carrier and the encapsulant.
Fig. 2 shows a schematic cross-sectional side view representation of a semiconductor package in which the insulation layer is applied to a rear surface of the die carrier and the encapsulant extends down to a rear surface of the insulation layer.
Fig. 3 shows a schematic cross-sectional side view representation of an example of a semiconductor package in which the insulation layer is a part of and contiguous with the encapsulant.
Fig. 4 shows a flow diagram of an exemplary method for fabricating a semiconductor package.
Fig. 5 shows a schematic cross-sectional side view representation of an example of a semiconductor device module comprising a package carrier such as that of Fig. 1 and a heat spreading layer on the rear surface.
Fig. 6 shows a schematic cross-sectional side view representation of an example of a semiconductor device module comprising a package carrier such as that of Fig. 1 and two heat spreading layers on the rear surface.
Fig. 7 shows a schematic cross-sectional side view representation of an example of a semiconductor device module comprising a package carrier such as that of Fig. 2 and a heat spreading layer on the rear surface.
Fig. 8 shows a schematic cross-sectional side view representation of an example of a semiconductor device module comprising a package carrier such as that of Fig. 2 and two heat spreading layers on the rear surface.
Fig. 9 shows a schematic cross-sectional side view representation of an example of a semiconductor device module comprising a package carrier such as that of Fig. 3 and a heat spreading layer on the rear surface.
Fig. 10 shows a schematic cross-sectional side view representation of an example of a semiconductor device module comprising a package carrier such as that of Fig. 3 and two heat spreading layers on the rear surface.
Fig. 11 shows a schematic cross-sectional side view representation of an example of a semiconductor device module including a heatsink applied to a lower surface and electrical or electronic components like, e.g., passive or logic components applied to an upper surface.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

### DETAILED DESCRIPTION

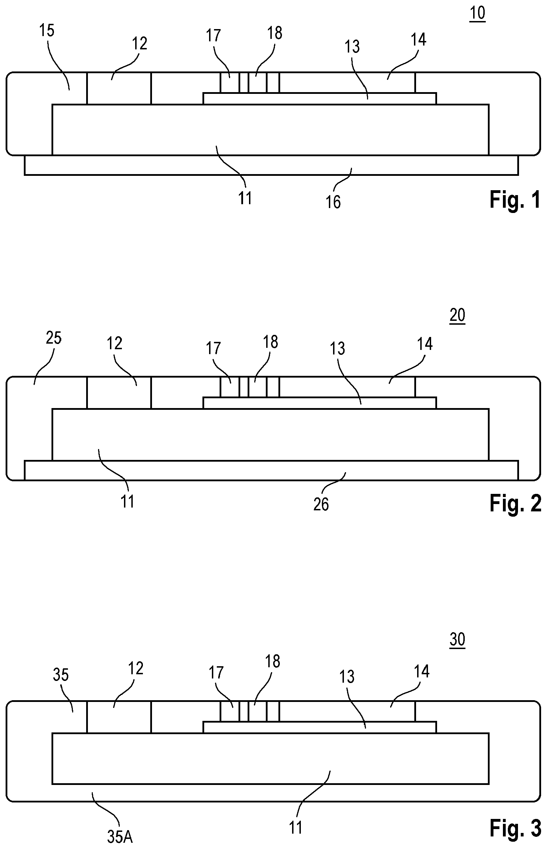

Fig. 1 shows a schematic cross-sectional side view representation of an example of a semiconductor package in which the insulation layer is applied to rear surfaces of the die carrier and the encapsulant.

More specifically, Fig. 1 shows a semiconductor package 10 which comprises a die carrier 11 comprising a first main face and a second main face opposite to the first main face and side faces connected between the first and second main faces. The die carrier 11 can, for example, be a portion of a leadframe.

The semiconductor package 10 further comprises a semiconductor die 13 disposed on the die carrier 11. The semiconductor die 13 can, for example, be one or more of a vertical transistor die, a MOSFET die, and an IGBT die. Furthermore the semiconductor die 13 can be fabricated from Si, or from a wide bandgap semiconductor material like SiC or GaN.

The semiconductor die 13 comprises a source pad and a drain pad, the source pad being disposed on a first main face of the semiconductor die 13 remote from the die carrier 11 and the drain pad being disposed on a second main face and connected with the first main face of the die carrier 11. The semiconductor die 11 may further comprise a gate pad and a source-sense pad, both being disposed on the first main face.

The semiconductor package 10 further comprises a first electrical connector 12 connected with the first main face of the die carrier 11, a second electrical connector 14 connected with the source pad, a third electrical connector 17, and a forth electrical connector 18 connected with the source-sense pad. The first, second, third and fourth electrical connectors 12, 14, 17, and 18 can be fabricated, for example, by galvanic plating of, for example, copper and can have thicknesses in a range from 5 µm to 1000 µm, for example.

The semiconductor package 10 further comprises an encapsulant 15 which at least partially covers the semiconductor die 13, the die carrier 11, and the first, second, third and fourth electrical connectors 12, 14, 17, and 18 in such a way that respective upper surfaces of these connectors are not covered by the encapsulant 15. In particular, it can be the case that respective upper surfaces of the first, second, third and fourth electrical connectors 12, 14, 17, and 18 are coplanar with an upper surface of the encapsulant 15 as is shown in Fig. 1. It is also possible that the upper surfaces are covered when fabricating the semiconductor package, and in a later step when fabricating the semiconductor device module, electrical vias are fabricated through the encapsulant so that in the final semiconductor device module the upper surface are partially covered by the encapsulant. In the embodiment of Fig. 1, the encapsulant 15 also covers the side faces of the die carrier 11, in particular all side faces of the die carrier 11. Also in the embodiment of Fig. 1, a lower most main face of the encapsulant 15 is coplanar with the second lower main face of the die carrier 11.

The first, second, third and fourth electrical connectors 12, 14, 17, and 18 can be fabricated, for example, by galvanic plating. However, other manufacturing techniques are also conceivable, such as those known from PCB assembly.

The encapsulant 15 may be comprised of a conventional mold compound like, for example, a resin material, in particular an epoxy resin material. Moreover, the encapsulant 15 can be applied in different aggregate states as, for example, in liquid form, as pellets, or as a granulate. Moreover, the encapsulant 15 can be made of a thermally conductive material to allow efficient heat dissipation to external application heat sinks. The material of the encapsulant 15 can, in particular, comprise a resin like an epoxy resin material filled with particles like, for example, SiO or other ceramic particles, or thermally conductive particles like, for examples, Al₂O₃, BN, AlN, Si₃N₄, diamond, or any other thermally conductive particles. The encapsulant 15 can also be made of a plateable mold compound.

The semiconductor package 10 further comprises an insulation layer 16 disposed on the second main face of the die carrier 11 and the lowermost main face of the encapsulant 15. The material of the insulation layer 16 may be different from that of the encapsulant and may in particular comprise one or more of an organic insulator, a polymer, a resin, a polyimide, an epoxy resin, an inorganic material, a ceramic material, or one of the above filled with ceramic particles.

Different methods can be applied to fabricate the insulation layer 16. Dependent on the material, the insulation layer 16 can be applied by one or more of compression molding, transfer molding, lamination, printing, and attaching a ceramic material like a ceramic layer.

By using highly insulating materials the thickness of the insulation layer 16 can be made very thin. In particular, a thickness of the insulation layer 16 may be in a range from 5 mm to 1000 µm.

Fig. 2 shows a schematic cross-sectional side view representation of a semiconductor package in which the insulation layer is applied to a rear surface of the die carrier and the encapsulant extends down to a rear surface of the insulation layer.

More specifically, Fig. 2 depicts a semiconductor package 20 which is similar to the semiconductor package 10 of Fig. 1 so that most of the reference signs of Fig. 1 were adopted and with regard to the function of the corresponding elements, reference is made to the above description.

An amendment as compared to Fig. 1 is that the encapsulant 25 also covers side walls, in particular all side walls of the insulation layer 26 so that a lowermost main face of the encapsulant 25 is coplanar with the lowermost main face of the insulation layer 26 and that the insulation layer 26 is covered on five sides by the encapsulant 25.

Fig. 3 shows a schematic cross-sectional side view representation of an example of a semiconductor package in which the insulation layer is a part of and contiguous with the encapsulant.

More specifically, Fig. 3 depicts a semiconductor devi6e package 30 which is similar to the semiconductor device package 10 of Fig. 1 so that most of the reference signs of Fig. 1 were adopted and with regard to the function of the corresponding elements, reference is made to the above description.

An amendment as compared to Fig. 1 is that within the encapsulant 35 the insulation layer 35A is a part of and contiguous with the encapsulant 35 in which case the encapsulant 35 needs to be electrically insulating and thermally conductive.

It should be mentioned that the present disclosure is not limited to the embodiments as depicted in Figs. 1 to 3. It is also possible that the source pad is arranged on the rear surface of the semiconductor die and the drain pad is arranged on the top surface of the semiconductor die (also known as "source-down" technology). Furthermore the disclosure is not limited to vertical transistors. The semiconductor die can also be a lateral semiconductor transistor die in which the source and drain pads are both arranged on one and the same surface, in particular on the top surface.

It should further be mentioned that instead of providing an insulation layer also a carrier could be used which comprises an integral insulation layer in which case no separate insulation layer would have to be applied. Examples for such a carrier could be an IMS (isolated metal substrate), DCB (direct copper bond) or AMB (active metal braze).

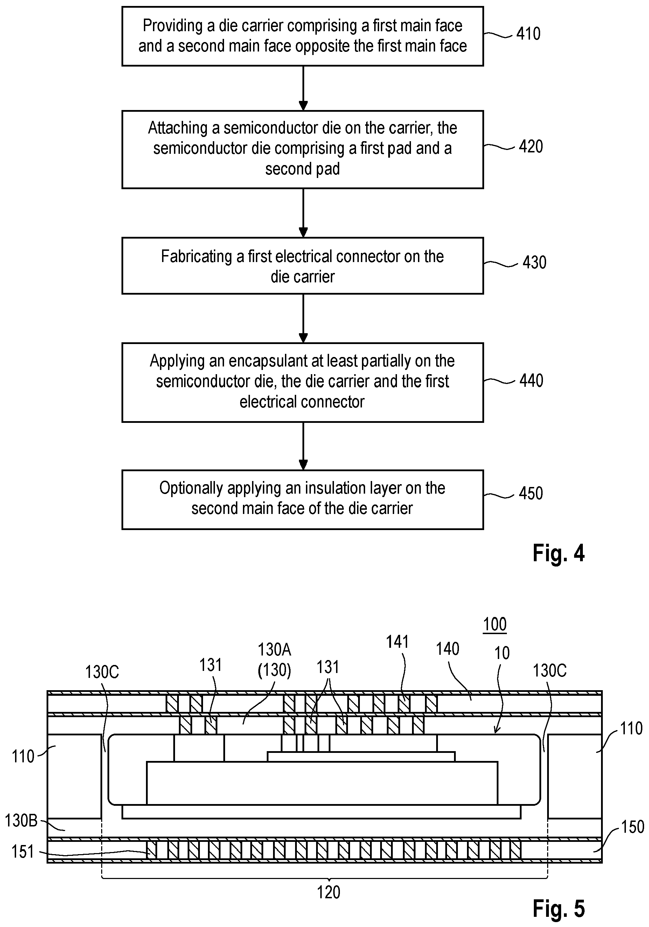

Fig. 4 shows a flow diagram of an exemplary method for fabricating a semiconductor package.

The method according to Fig. 4 comprises providing a die carrier comprising a first main face and a second main face opposite to the first main face (410), attaching a semiconductor die on the die carrier, the semiconductor die comprising a first pad and a second pad, (420), fabricating a second electrical connector on the first pad (430), applying an encapsulant at least partially on the semiconductor die, the die carrier, and the first electrical connector (440), and applying an insulation layer on the second main face of the die carrier (450) if the carrier does not already have an integral insulating layer.

According to an embodiment of the method applying the insulation layer is performed by one or more of compression molding, transfer molding, lamination, and attaching a ceramic material like a ceramic layer.

According to an embodiment of the method after applying the insulation layer, the insulation properties of the semiconductor package can be tested by, for example, applying a DC voltage of 4,2 kV for 2s.

Further embodiments of the method can be formed by adding aspects or features which were described above in connection with the semiconductor package according to the first aspect.

Fig. 5 shows a schematic cross-sectional side view representation of an example of a semiconductor device module comprising a package carrier having an opening in which a semiconductor package such as that of Fig. 1 is inserted.

The semiconductor device module 100 as shown in Fig. 5 comprises a package carrier 110 which in the embodiment of Fig. 5 is a printed circuit board (PCB), but can also be something else, in particular one or more of an insulator layer, a laminate layer, an FR4 layer, a glass layer, a metallic layer, in particular a Cu or Al layer, or any combination of these layers. The package carrier 110 comprises an opening 120 and should in general be suitable to receive and support a semiconductor die package 10 within the opening 120 of the package carrier 110.

The semiconductor device module 100 further comprises a first insulation layer 130 which may essentially completely cover the package carrier 110 which means that the first insulation layer 130 comprises a first horizontal upper layer 130A, a second horizontal lower layer 130B and vertical layers 130C between the first and second layers 130A and 130B which vertical layers 130C may have the form of a contiguous ring which surrounds the opening 120 of the package carrier 110. The first insulation layer 130 may be a polymer layer formed by laminating onto the package carrier 110. As can be seen, the semiconductor package 10 is configured so that the lateral dimensions of the semiconductor package 10 are only slightly smaller than the lateral dimensions of the opening 110.

The first insulation layer 130 comprises electrical vias 131 which are connected with the first, second, third, and fourth electrical connectors 12, 14, 17, and 18 of the semiconductor package 10. The electrical vias 131 can, for example, be formed by galvanic plating of, for example, copper.

The semiconductor device module 100 further comprises a second insulation layer 140 disposed above a first main face of the first insulation layer 130 and a third insulation layer 150 disposed above a second main face of the first insulation layer 130. The second insulation layer 140 also comprises electrical vias 141 which are connected with the electrical visa 131 via an interconnection layer. The third insulation layer 150 also comprises electrical vias 151 which are connected with the second horizontal lower layer 130B. The electrical vias 141 and 151 can, for example, also be formed by galvanic plating of, for example, copper.

The function of the electrical vias 131 and 141 is twofold, namely to make electrical contact with the semiconductor die 130 and to dissipate heat. In contrast, the electrical vias 151 only have the function of providing heat dissipation downwards.

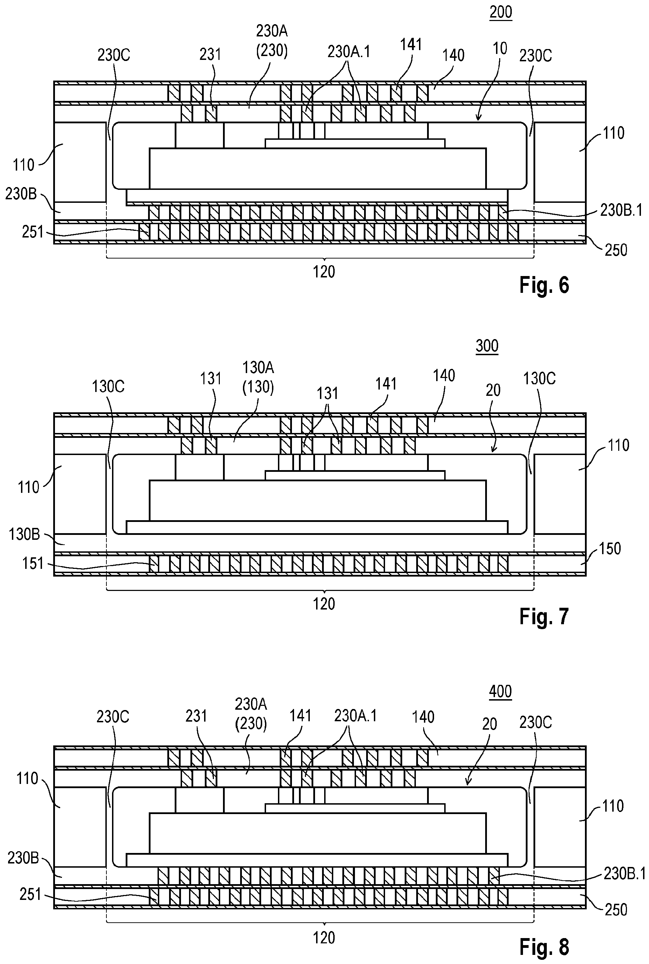

Fig. 6 shows a schematic cross-sectional side view representation of an example of a semiconductor device module comprising a package carrier such as that of Fig. 1 and two heat spreading layers on the rear surface.

More specifically, Fig. 6 depicts a semiconductor device module 200 which is similar to the semiconductor device module 100 of Fig. 5 so that a few reference signs of Fig. 5 were adopted and with regard to the function of the corresponding elements, reference is made to the above description.

An amendment as compared to Fig. 5 is that the first insulation layer 130 of Fig. 5 is now replaced by a first insulation layer 230. which may also essentially completely cover the package carrier 110 which means that the first insulation layer 230 comprises a first horizontal upper layer 230A, a second horizontal lower layer 230B and vertical layers 230C between the first and second layers 230A and 230B which vertical layers 230C may have the form of a contiguous ring which surrounds the opening 120 of the package carrier 110. The first insulation layer 230 may be a polymer layer formed by laminating onto the package carrier 110. As can be seen, the semiconductor package 10 is configured so that the lateral dimensions of the semiconductor package 10 are only slightly smaller than the lateral dimensions of the opening 110.

The first horizontal upper layer 230A comprises electrical vias 230A.1 which are connected with the first, second, third, and fourth electrical connectors 12, 14, 17, and 18 of the semiconductor package 10. The electrical vias 230A.1 can, for example, be formed by galvanic plating of, for example, copper.

A difference as compared to the first insulation layer 130 of Fig. 1 is that the second horizontal layer 230B comprises electrical vias 230B.1 which are connected with electrical vias 251 of a third insulation layer 250 applied to a rear surface of the second horizontal layer 230B. In this way tow heat spreading layers are provided on the rear surface of the isolation layer 16 of the semiconductor package 10.

Fig. 7 shows a schematic cross-sectional side view representation of an example of a semiconductor device module comprising a package carrier such as that of Fig. 2 and a heat spreading layer on the rear surface.

More specifically, Fig. 7 depicts a semiconductor device module 300 which is similar to the semiconductor device module 100 of Fig. 5 so that most of the reference signs of Fig. 5 were adopted and with regard to the function of the corresponding elements, reference is made to the above description.

A difference as compared to the semiconductor device module 100 of Fig. 5 is that a semiconductor package 20 according to Fig. 2 is inserted into the opening 120 of the package carrier 110 instead of a semiconductor package 10 according to Fig. 1 as was the case with the embodiment of Fig. 5.

Fig. 8 shows a schematic cross-sectional side view representation of an example of a semiconductor device module comprising a package carrier such as that of Fig. 2 and two heat spreading layers on the rear surface.

More specifically, Fig. 8 depicts a semiconductor device module 400 which is similar to the semiconductor device module 200 of Fig. 6 so that most of the reference signs of Fig. 6 were adopted and with regard to the function of the corresponding elements, reference is made to the above description.

A difference as compared to the semiconductor device module 200 of Fig. 6 is that a semiconductor package 20 according to Fig. 2 is inserted into the opening 120 of the package carrier 110 instead of a semiconductor package 10 according to Fig. 1 as was the case with the embodiment of Fig. 6.

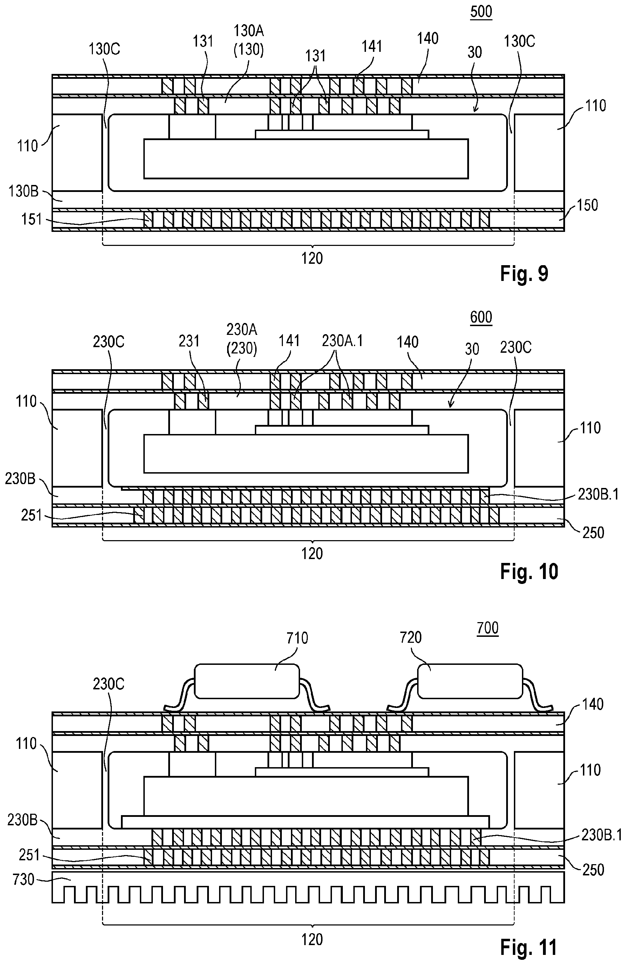

Fig. 9 shows a schematic cross-sectional side view representation of an example of a semiconductor device module comprising a package carrier such as that of Fig. 3 and a heat spreading layer on the rear surface.

More specifically, Fig. 9 depicts a semiconductor device module 500 which is similar to the semiconductor device module 100 of Fig. 5 so that most of the reference signs of Fig. 5 were adopted and with regard to the function of the corresponding elements, reference is made to the above description.

A difference as compared to the semiconductor device module 100 of Fig. 5 is that a semiconductor package 30 according to Fig. 3 is inserted into the opening 120 of the package carrier 110 instead of a semiconductor package 10 according to Fig. 1 as was the case with the embodiment of Fig. 3.

Fig. 10 shows a schematic cross-sectional side view representation of an example of a semiconductor device module comprising a package carrier such as that of Fig. 3 and two heat spreading layers on the rear surface.

More specifically, Fig. 10 depicts a semiconductor device module 600 which is similar to the semiconductor device module 200 of Fig. 6 so that most of the reference signs of Fig. 6 were adopted and with regard to the function of the corresponding elements, reference is made to the above description.

A difference as compared to the semiconductor device module 200 of Fig. 6 is that a semiconductor package 30 according to Fig. 3 is inserted into the opening 120 of the package carrier 110 instead of a semiconductor package 10 according to Fig. 1 as was the case with the embodiment of Fig. 6.

The present disclosure also relates to system modules in which two or more semiconductor device modules are integrated in a package carrier such as in Fig. 1 and electrically connected with each other to form one or more of a B6 half bridge, an H bridge, a parallel connection between any switching component and/or an antiparallel freewheeling diode, SR topologies, buck-boost converters, DC/DC converters, or AC-switches.

Furthermore other electrical or electronic devices can be integrated with the semiconductor device module such as, for example, gate drivers, controllers, sensors, connectivity devices (Bluetooth or WiFi devices), passive devices etc. Such devices can be embedded in the package carrier in the same way as the semiconductor die or they can be placed on an outer surface of the package carrier.

An example thereof is shown in Fig. 11 which shows a schematic cross-sectional side view representation of an example of a semiconductor device module including a heatsink applied to a lower surface and electrical or electronic components like, e.g., passive or logic components applied to an upper surface.

More specifically, Fig. 11 depicts a semiconductor device module 700 which is similar to the semiconductor device module 300 of Fig. 8 so that most of the reference signs of Fig. 8 were adopted and with regard to the function of the corresponding elements, reference is made to the above description.

A difference as compared to the semiconductor device module 200 of Fig. 8 is that additional components are applied to the semiconductor module 300, in particular one or more passive components 710, one or more logic components 720, and a heatsink 730. The passive components 710 and the logic components 720 are preferably disposed on an upper surface of the module and the heatsink 730 on a lower surface. The passive components 710 could be, for example, resistors, coils or capacitors, and the logic components 720 could be, for example drivers circuits for driving the semiconductor dies. One or more of the passive components 710, the logic components 720 and the heatsink 730 could also be embedded.

### EXAMPLES

In the following specific examples of the present disclosure are described.

Example 1 is a semiconductor package, comprising a die carrier comprising a first main face and a second main face opposite to the first main face, a semiconductor die disposed on the die carrier, the semiconductor die comprising a first pad and a second pad, a first electrical connector disposed on the first pad, an encapsulant at least partially covering the semiconductor die, the die carrier, and the first electrical connector, and an insulation layer disposed on the second main face of the die carrier.

Example 2 is the semiconductor package according to Example 1, wherein the semiconductor die comprises a vertical transistor in which the first pad is disposed on the first main face remote from the die carrier and the second pad is disposed on a second main face and connected with the first main face of the die carrier.

Example 3 is the semiconductor package according to Example 2, wherein the first pad is a source pad and the second pad is a drain pad.

Example 4 is the semiconductor package according to any one of the preceding Examples, further comprising a second electrical connector connected with the first main face of the die carrier, wherein the encapsulant also partially covers the second electrical connector.

Example 5 is the semiconductor package according to any one of the preceding Examples, wherein upper surfaces of one or more of the first electrical connector and the second electrical connector are not covered by the encapsulant.

Example 6 is the semiconductor package according to Example 5, wherein a main surface of the encapsulant is coplanar with the upper surfaces of the first electrical connector and the second electrical connector.

Example 7 is the semiconductor package according to any one of the preceding Examples, further comprising a further pad disposed on the first main face of the semiconductor die; and a further electrical connector disposed on the further pad, wherein a surface of the further electrical connector is not covered by the encapsulant.

Example 8 is semiconductor package according to Example 7, wherein a main surface of the encapsulant is coplanar with the exposed surface of the further electrical connector.

Example 9 is the semiconductor package according to Example 7 or 8, wherein the further pad comprises a gate pad.

Example 10 is the semiconductor package according to Example 1, wherein the semiconductor die comprises a lateral transistor in which the first pad comprises a source pad and the second pad comprises a drain pad and both the first and second pads are disposed on the first main face remote from the die carrier.

Example 11 is semiconductor package according to any one of the preceding Examples, further comprising a leadframe, the die carrier being part of the leadframe.

Example 12 is the semiconductor package according to any one of the preceding Examples, wherein the insulation layer comprises one or more of an organic insulator, a polymer, a resin, an epoxy resin, a ceramic material, or one of the above filled with ceramic particles.

Example 13 is the semiconductor package according to any one of the preceding Examples, wherein instead of the insulation layer a die carrier is provided which comprises an integral insulation layer.

Example 14 is the semiconductor package according to any one of the preceding Examples, wherein the insulation layer is a part of and contiguous with the encapsulant.

Example 15 is the semiconductor package according to any one of the preceding Examples, further comprising a source sense pad disposed on the first main face of the semiconductor die; and a forth electrical connector disposed on the gate pad, wherein a surface of the forth electrical connector is exposed.

Example 16 is the semiconductor package according to Example 15, wherein a main surface of the encapsulant is coplanar with the exposed surface of the forth electrical connector.

Example 17 is the semiconductor package according to any one of the preceding Examples, wherein the die carrier comprises rounded edges.

Example 18 is the semiconductor package according to any one of the preceding Examples, wherein the die carrier comprises sidewalls connecting the first main face and the second main face with each other, and the encapsulant covers the first main face and the side faces of the die carrier.

Example 19 is the semiconductor package according to any one of the preceding Examples, wherein the insulation layer and the encapsulant comprise different materials.

Example 20 is a semiconductor device module comprising a package carrier comprising an opening, wherein a semiconductor package according to any one of the preceding claims is disposed in the opening.

Example 21 is the semiconductor device module according to Example 20, wherein the package carrier is a printed circuit board.

Example 22 is the semiconductor device module) according to Example 20 or 21, further comprising a first insulation layer covering at least portions of the package carrier and the semiconductor package.

Example 23 is the semiconductor device module according to Example 22, wherein the first insulation layer comprises electrical vias connected with the first electrical connector and the second electrical connector.

Example 24 is the semiconductor device module according to Example 22 or 23, further comprising a second insulation layer disposed above a first main face of the first insulation layer and a third insulation layer disposed above a second main face of the first insulation layer.

Example 25 is the semiconductor device module according to any one of Examples, further comprising a heatsink applied to a lower surface and electrical or electronic components applied to an upper surface.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A semiconductor package (10; 20; 30), comprising:
- a die carrier (11) comprising a first main face and a second main face opposite to the first main face;
- a semiconductor die (13) disposed on the die carrier (11), the semiconductor die (13) comprising a first pad and a second pad;
- a first electrical connector (14) disposed on the first pad;
- an encapsulant (15; 25; 35) at least partially covering the semiconductor die (13), the die carrier (11), and the first electrical connector (14); and
- an insulation layer (16; 26; 35A) disposed on the second main face of the die carrier (11).

2. The semiconductor package (10; 20; 30) according to claim 1, wherein
the semiconductor die (13) comprises a vertical transistor in which the first pad is disposed on the first main face remote from the die carrier (11) and the second pad is disposed on a second main face and connected with the first main face of the die carrier (11).

3. The semiconductor package (10; 20; 30) according to claim 2, wherein
the first pad is a source pad and the second pad is a drain pad.

4. The semiconductor package (10; 20; 30) according to any one of the preceding claims, further comprising a second electrical connector (12) connected with the first main face of the die carrier (11), wherein the encapsulant also partially covers the second electrical connector.

5. The semiconductor package (10; 20; 30) according to any one of the preceding claims, wherein
upper surfaces of one or more of the first electrical connector (14) and the second electrical connector (12) are not covered by the encapsulant (15; 25; 35).

6. The semiconductor package (10; 20; 30) according to claim 5, wherein
a main surface of the encapsulant (15; 25; 35) is coplanar with the upper surfaces of the first electrical connector (14) and the second electrical connector (12).

7. The semiconductor package (10; 20; 30) according to any one of the preceding claims, further comprising a further pad disposed on the first main face of the semiconductor die (13); and
a further electrical connector (17) disposed on the further pad, wherein a surface of the further electrical connector (17) is not covered by the encapsulant (15; 25; 35).

8. The semiconductor package (10; 20; 30) according to claim 7, wherein
a main surface of the encapsulant (15; 25; 35) is coplanar with the exposed surface of the further electrical connector (17) .

9. The semiconductor package (10; 20; 30) according to claim 7 or 8, wherein
the further pad comprises a gate pad.

10. The semiconductor package (10; 20; 30) according to claim 1, wherein
the semiconductor die comprises a lateral transistor in which the first pad comprises a source pad and the second pad comprises a drain pad and both the first and second pads are disposed on the first main face remote from the die carrier (11) .

11. The semiconductor package (10; 20; 30) according to any one of the preceding claims, further comprising a leadframe, the die carrier (11) being part of the leadframe.

12. The semiconductor package (10; 20) according to any one of the preceding claims, wherein
the insulation layer (16; 26) comprises one or more of an organic insulator, a polymer, a resin, an epoxy resin, a ceramic material, or one of the above filled with ceramic particles.

13. The semiconductor package (30) according to any one of the preceding claims, wherein
instead of the insulation layer a die carrier is provided which comprises an integral insulation layer.

14. The semiconductor package (30) according to any one of the preceding claims, wherein the insulation layer (35A) is a part of and contiguous with the encapsulant (35).

15. A semiconductor device module (100; 200; 300) comprising
- a package carrier (110) comprising an opening (120), wherein a semiconductor package (10; 20; 30) according to any one of the preceding claims is disposed in the opening (120).

16. The semiconductor device module (100; 200; 300) according to claim 15, wherein
the package carrier (110) is a printed circuit board.

17. The semiconductor device module (100; 200; 300) according to claim 15 or 16, further comprising
a first insulation layer (130; 230) covering at least portions of the package carrier (110) and the semiconductor package (10; 20; 30).

18. The semiconductor device module (100; 200; 300) according to claim 17, wherein
the first insulation layer (130; 230) comprises electrical vias connected with the first electrical connector (14) and the second electrical connector (12).

19. The semiconductor device module (100; 200; 300) according to claim 17 or 18, further comprising
a second insulation layer (140) disposed above a first main face of the first insulation layer (130; 230) and a third insulation layer (150; 250) disposed above a second main face of the first insulation layer (130; 230).

20. The semiconductor device module (700) according to any one of claims 15 to 19, further comprising
a heatsink (730) applied to a lower surface and electrical or electronic components (710; 720) applied to an upper surface.
